# EUROPEAN PATENT APPLICATION

(11) **EP 3 553 818 A1**
(43) Date of publication of application: **16.10.2019**
(21) Application number: 17898385.4
(22) Date of filing: 28.02.2017
(51) Int. Cl.: H01L 25/00

(54) **PHOTOELECTRIC HYBRID PACKAGE ASSEMBLY**

(71) Applicant: Huawei Technologies Co., Ltd., Longgang District Shenzhen, Guangdong 518129 (CN)
(72) Inventor: GAO, Lei, Shenzhen Guangdong 518129 (CN); ZENG, Li, Shenzhen Guangdong 518129 (CN); SONG, Xiaolu, Shenzhen Guangdong 518129 (CN); DONG, Zhen, Shenzhen Guangdong 518129 (CN)
(74) Representative: Goddar, Heinz J.
(86) International application number: PCT/CN2017/075270
(87) International publication number: WO 2018/157314

(57) **Abstract**

This application provides an optical/electrical hybrid package assembly, including: a mother PCB; a first daughter-PCB, the first daughter-PCB being disposed on one of surfaces of the mother PCB; an optical chip, disposed on one surface of the first daughter-PCB; and an electrical chip, disposed on the other surface of the first daughter-PCB. In the optical/electrical hybrid package assembly provided in this application, while a high integrated level of a device is ensured, working stability and reliability of the optical chip and the electrical chip are effectively improved.

## Description

### TECHNICAL FIELD

This application relates to the field of chip packaging technologies, and in particular, to an optical/electrical hybrid package assembly.

### BACKGROUND

With rapid development of next-generation Internet, mobile communication, cloud computing, and big data, optical interconnection using light as information carriers becomes a basis for development of information society and smart cities. In a solution for implementing a physical layer of optical interconnection, an optical chip and an electrical chip that are independently packaged are usually integrated into a PCB to implement required system functions. As a data volume increases, the optical chip and the electrical chip may be mixed and packaged together in a two dimensional (two dimensional, 2D for short) manner to increase volume density. The optical chip and the electrical chip may be further mixed and packaged together in a three dimensional (three dimensional, 3D for short) manner to further increase volume density.

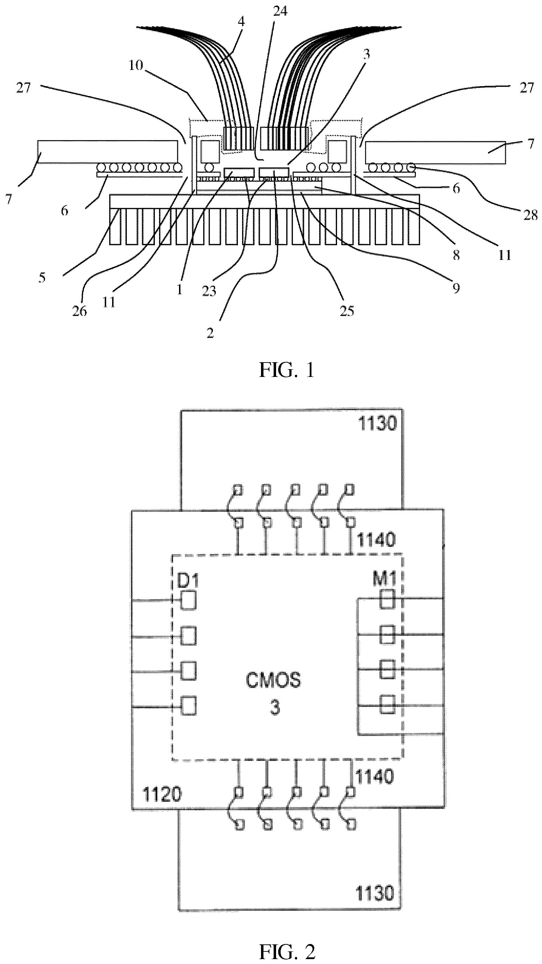

As shown in FIG. 1, a 2D optical/electrical hybrid package is provided. An optical chip 2 and an electrical chip 1 are attached on a same printed circuit board (Printed Circuit Board, PCB for short) 7 for 2D integration. A heat sink channel 27 covers chips, a substrate 6, and a heat sink 5 below. An optical input/output channel is an optical fiber array that faces upward. However, both an optical chip and an electrical chip are arranged on one surface of a PCB, and this arrangement is a 2D optical/electrical hybrid package, resulting in relatively low density.

A 3D optical/electrical hybrid package is provided to increase volume density. As shown in FIG. 2, a chip 3 is flip-bonded on a photonic chip 1120, and is connected to a modulator. An optoelectronic detector and an RF transmission line 1140 are bonded and connected to a PCB 1130 by using a lead. Specifically, the 3D optical/electrical hybrid package is a 3D structure implemented by stacking an optical chip on an electrical chip. This solution implements a high-density optical/electrical hybrid package. However, there is a problem that chips easily fail to work normally or have a relatively high failure rate.

### SUMMARY

This application provides an optical/electrical hybrid package assembly, to resolve a problem that chips often fail to work normally or have a relatively high failure rate in an optical/electrical hybrid package structure in the prior art.

This application provides an optical/electrical hybrid package assembly, including:
a mother PCB;
a first daughter-PCB, the first daughter-PCB being disposed on one of surfaces of the mother PCB;
an optical chip, disposed on one surface of the first daughter-PCB; and
an electrical chip, disposed on the other surface of the first daughter-PCB.

In the foregoing optical/electrical hybrid package assembly, the optical chip is disposed on one surface of the first daughter-PCB, and the electrical chip is disposed on the other surface of the first daughter-PCB, so that the optical chip is effectively isolated from the electrical chip. A high-density package structure is implemented. In addition, when the optical chip is stacked on the electrical chip, there is a problem that chips often fail to work normally or have a relatively high failure rate, and this problem is overcome. Working stability and reliability of the optical chip and the electrical chip are ensured, and practicability of the optical/electrical hybrid package assembly is effectively improved.

In a possible design, the optical/electrical hybrid package assembly further includes: an electrical chip heat sink, where the electrical chip heat sink is configured to be laminated to the electrical chip.

In the foregoing optical/electrical hybrid package assembly, the electrical chip heat sink laminated to the electrical chip is disposed, so that heat dissipation may be rapidly performed on the electrical chip to improve quality and efficiency of heat dissipation. In this way, a working temperature of the electrical chip does not become excessively high, and working stability and reliability of the electrical chip are further ensured.

In a possible design, the electrical chip is disposed between the mother PCB and the first daughter-PCB.

In a possible design, a mounting region configured to mount the electrical chip heat sink is disposed on the mother PCB.

In the foregoing optical/electrical hybrid package assembly, when the electrical chip is disposed between the mother PCB and the first daughter-PCB, the mounting region configured to mount the electrical chip heat sink is disposed, so that quality and efficiency of performing heat dissipation on the electrical chip are effectively ensured.

In a possible design, the mounting region is a groove structure provided on the mother PCB; or, the mounting region is a through hole structure provided on the mother PCB.

In the foregoing optical/electrical hybrid package assembly, when the electrical chip is disposed between the mother PCB and the first daughter-PCB, the mounting region is provided as the groove structure or the through hole structure on the mother PCB. In manners that can be implemented for the mounting region, quality and efficiency of performing heat dissipation on the electrical chip are ensured to the greatest extent, and there are varied manners of providing the mounting region, so that application scope of the optical/electrical hybrid package assembly is further improved.

In a possible design, the optical chip is disposed between the mother PCB and the first daughter-PCB.

In a possible design, a through hole configured to be used as an optical input/output channel of the optical chip is provided on the mother PCB.

In the foregoing optical/electrical hybrid package assembly, the through hole is provided, so that it can be effectively ensured that an optical signal passes through the through hole to reach the optical chip, and working stability and reliability of the optical chip are further improved.

In a possible design, the optical/electrical hybrid package assembly further includes: an optical chip heat sink, where the optical chip heat sink is configured to be laminated to the optical chip.

In the foregoing optical/electrical hybrid package assembly, the disposed optical chip heat sink performs heat dissipation on the optical chip, so that stability and reliability of using the optical chip are effectively ensured, and safety and reliability of using the optical/electrical hybrid package assembly are further improved.

In a possible design, the optical/electrical hybrid package assembly further includes: one or more adjacent optical chips, where the adjacent optical chip and the electrical chip are located on a same surface of the first daughter-PCB, and a gap is provided between the adjacent optical chip and the electrical chip.

In the foregoing optical/electrical hybrid package assembly, application scope of the optical/electrical hybrid package assembly is effectively extended. In addition, performance of high-frequency communication between the adjacent optical chip and the electrical chip is further ensured, so that stability and reliability of using the optical/electrical hybrid package assembly are improved.

In a possible design, the optical/electrical hybrid package assembly further includes: one or more adjacent electrical chips, where the adjacent electrical chip and the optical chip are located on a same surface of the first daughter-PCB, and a gap is provided between the adjacent electrical chip and the optical chip.

In the foregoing optical/electrical hybrid package assembly, application scope of the optical/electrical hybrid package assembly is effectively extended. In addition, performance of high-frequency communication between the adjacent electrical chip and the optical chip is further ensured, so that stability and reliability of using the optical/electrical hybrid package assembly are improved.

In a possible design, the optical/electrical hybrid package assembly further includes: one or more second daughter-PCBs, where the second daughter-PCB and the first daughter-PCB are disposed in a stacked manner, at least one chip is disposed on both a top surface and a bottom surface of the second daughter-PCB, and the chips disposed on a top surface and a bottom surface of the first daughter-PCB and the chips disposed on the top surface and the bottom surface of the second daughter-PCB include at least one optical chip and one electrical chip.

In the foregoing optical/electrical hybrid package assembly, the one or more second daughter-PCBs and the first daughter-PCB are disposed in a stacked manner. While working stability and reliability of the optical chip and the electrical chip are ensured, volume density in the optical/electrical hybrid package assembly is further improved, and there are varied forms of providing the optical/electrical hybrid package assembly, so that practicability and application scope of the optical/electrical hybrid package assembly are further improved.

In a possible design, the optical/electrical hybrid package assembly further includes: a fixing apparatus disposed on a surface of the mother PCB, where the fixing apparatus is configured to integrally package the first daughter-PCB, the optical chip, and the electrical chip.

In the foregoing optical/electrical hybrid package assembly, the disposed fixing apparatus may integrally package the first daughter-PCB, the optical chip, and the electrical chip, so that working stability and reliability of the foregoing components are effectively ensured, service life of the optical/electrical hybrid package assembly is extended, and safety and reliability of using the optical/electrical hybrid package assembly are improved.

In a possible design, the first daughter-PCB includes: a first daughter-PCB layer and a second daughter-PCB layer, where the first daughter-PCB layer is connected to the second daughter-PCB layer by using an interposer.

In the foregoing optical/electrical hybrid package assembly, the first daughter-PCB is disposed to include the first daughter-PCB layer, the second daughter-PCB layer, and the interposer disposed between the first daughter-PCB layer and the second daughter-PCB layer. The first daughter-PCB layer is effectively isolated from the second daughter-PCB layer, so that mutual interference between a process of soldering the optical chip and a process of soldering the electrical chip is avoided, stability and reliability of mounting the optical chip and the electrical chip are ensured, and stability and reliability of using the optical/electrical hybrid package assembly are further improved. In addition, service life of the optical/electrical hybrid package assembly is extended.

In a possible design, a communications port configured to be used as the optical input/output channel of the optical chip is disposed on the fixing apparatus.

### BRIEF DESCRIPTION OF DRAWINGS

FIG. 1 is a schematic structural diagram of a 2D optical/electrical hybrid package in the prior art according to this application;
FIG. 2 is a schematic structural diagram of a 3D optical/electrical hybrid package in the prior art according to this application;
FIG. 3 is a schematic structural diagram of an embodiment of an optical/electrical hybrid package assembly according to this application;
FIG. 4 is a schematic structural diagram of another embodiment of an optical/electrical hybrid package assembly according to this application;
FIG. 5 is a schematic structural diagram of still another embodiment of an optical/electrical hybrid package assembly according to this application;
FIG. 6 is a schematic structural diagram of yet another embodiment of an optical/electrical hybrid package assembly according to this application;
FIG. 7 is a schematic structural diagram of another embodiment of an optical/electrical hybrid package assembly according to this application;
FIG. 8 is a schematic structural diagram of a further embodiment of an optical/electrical hybrid package assembly according to this application;
FIG. 9 is a schematic structural diagram of still another embodiment of an optical/electrical hybrid package assembly according to this application; and
FIG. 10 is a schematic structural diagram of yet another embodiment of an optical/electrical hybrid package assembly according to this application.

In the drawings:
100, electrical chip heat sink; 101, optical chip heat sink; 2, first daughter-PCB; 201, first daughter-PCB layer; 202, second daughter-PCB layer; 3, optical chip; 4, electrical chip; 5, mother PCB; 501, mounting region; 6, adjacent optical chip; 7, adjacent electrical chip; 8, interposer; 9, fixing apparatus; 901, communications port; and 10, second daughter-PCB.

### DESCRIPTION OF EMBODIMENTS

This application relates to the field of chip packaging technologies. At present, a chip package structure in the prior art includes a 2D optical/electrical hybrid package structure and a 3D optical/electrical hybrid package structure. For the 2D optical/electrical hybrid package structure, reference may be made to FIG. 1. An optical chip 2 and an electrical chip 1 in FIG. 1 are attached on a same PCB 7 to implement 2D integration. However, in the foregoing structure, the optical chip 2 and the electrical chip 1 are both arranged on a same surface of the PCB 7, and utilization of the other surface of the PCB 7 is relatively low. As a result, volume density of device packaging is low.

To overcome a problem that volume density of the 2D optical/electrical hybrid package structure in the prior art is relatively low, a 3D optical/electrical hybrid package is provided. As shown in FIG. 2, a chip 3 is flip-bonded on a photonic chip 1120, and is connected to a modulator. An optoelectronic detector and an RF transmission line 1140 are bonded and connected to a PCB 1130 by using a lead. It can be learned according to the structure described above that in the 3D optical/electrical hybrid package in the prior art, an optical chip and an electrical chip are disposed to be a stack structure to improve volume density. However, during actual working, because the optical chip and the electrical chip are disposed in a stacked manner, if the electrical chip below generates a large amount of heat, the optical chip above is severely affected. This may cause a problem that, the optical chip and/or the electrical chip cannot work normally and a failure rate of chips is increased.

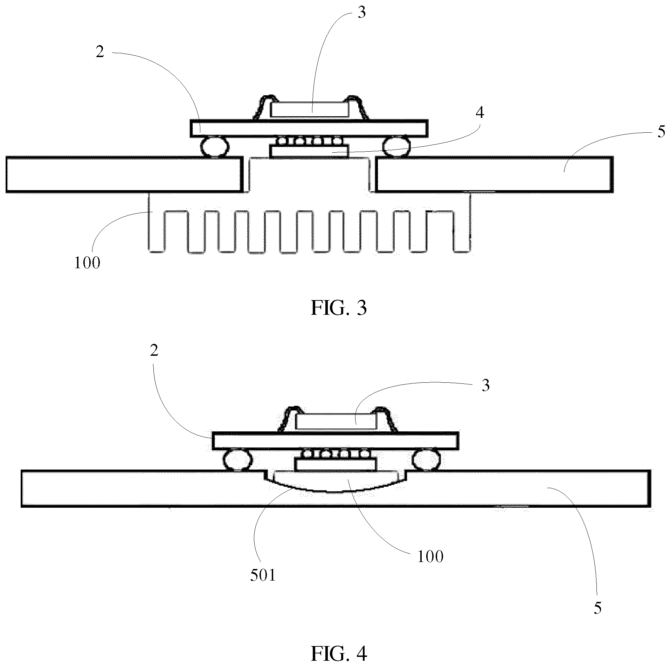

FIG. 3 is a schematic structural diagram of an embodiment of an optical/electrical hybrid package assembly according to this application. As shown in FIG. 3, this application relates to an optical/electrical hybrid package assembly, and intends to resolve the foregoing technical problems in the prior art. Specifically, the optical/electrical hybrid package assembly includes:
a mother PCB 5;
a first daughter-PCB 2, the first daughter-PCB 2 being disposed on one of surfaces of the mother PCB 5;
an optical chip 3, disposed on one surface of the first daughter-PCB 2; and
an electrical chip 4, disposed on the other surface of the first daughter-PCB 2.

The mother PCB 5 is configured to carry an electrical component to form an electronic product having a particular function. The first daughter-PCB 2 is disposed on one of surfaces of the mother PCB 5. That is, the first daughter-PCB 2 may be disposed on a top surface or a bottom surface of the mother PCB 5. During Specific design, the first daughter-PCB 2 and the mother PCB 5 are electrically connected. An optional manner of implementing the connection is: A manner of reflow soldering is used to implement an electrical connection between the first daughter-PCB 2 and the mother PCB 5. Specifically, the first daughter-PCB 2 may be attached on the mother PCB 5 in a manner of "solder ball" or "solder". In addition, circuits are printed on both opposite surfaces of the first daughter-PCB 2. The circuit is configured to implement data processing and/or data communication. Therefore, to ensure communication quality and interconnection density between the first daughter-PCB 2 and the mother PCB 5, ceramic substrates may be chosen for the first daughter-PCB 2 and the mother PCB 5. Certainly, a conventional polymer substrate may be chosen.

In addition, the optical chip 3 and the electrical chip 4 are respectively disposed on a top surface and a bottom surface of the first daughter-PCB 2. For the optical chip 3 and the electrical chip 4, an arrangement manner that can be implemented includes: For the optical chip 3, the optical chip 3 may be disposed to be electrically connected to the first daughter-PCB 2 by using wire seating, or, the optical chip 3 may be disposed to be attached on the first daughter-PCB 2 in a manner of flip-chip soldering; for the electrical chip 4, the electrical chip 4 may be disposed to be attached on the first daughter-PCB 2 in a manner of flip-chip soldering. A position arrangement manner that can be implemented includes: The optical chip 3 is disposed on the top surface of the first daughter-PCB 2, and the electrical chip 4 is disposed on the bottom surface of the first daughter-PCB 2; or, the optical chip 3 is disposed on the bottom surface of the first daughter-PCB 2, and the electrical chip 4 is disposed on the top surface of the first daughter-PCB 2. In this way, the first daughter-PCB 2 may be configured to carry electrical components (including the optical chip 3 and the electrical chip 4), and in addition, the optical chip 3 and the electrical chip 4 may be further effectively integrated, so that a high-density package structure is implemented and space occupied on the mother PCB 5 is reduced. The optical chip 3 is isolated from the electrical chip 4, so that an amount of heat transferred between the optical chip 3 and the electrical chip 4 is effectively reduced. Compared with a package structure in which the optical chip 3 is stacked on the electrical chip 4 in the prior art, quality and efficiency of heat dissipation between the optical chip 3 and the electrical chip 4 are effectively improved, and working stability and reliability of the optical chip 3 and the electrical chip 4 are effectively ensured.

In the optical/electrical hybrid package assembly provided in this application, the optical chip 3 is disposed on one surface of the first daughter-PCB 2, and the electrical chip 4 is disposed on the other surface of the first daughter-PCB 2, so that the optical chip 3 is effectively isolated from the electrical chip 4. A high-density package structure is implemented. In addition, when the optical chip 3 is stacked on the electrical chip 4, there is a problem that chips often fail to work normally or have a relatively high failure rate, and this problem is overcome. Working stability and reliability of the optical chip 3 and the electrical chip 4 are ensured, and practicability of the optical/electrical hybrid package assembly is effectively improved.

It can be learned by continuing to refer to FIG. 3 that the optical chip 3 is configured to: convert an optical signal into an electrical signal, and transfer the electrical signal obtained through conversion to the electrical chip 4 by using the first daughter-PCB 2, and the electrical chip 4 receives the electrical signal and then performs analysis processing on the electrical signal. Therefore, in a working process of the optical chip 3 and the electrical chip 4, the electrical chip 4 generates heat more easily as compared with the optical chip 3. Therefore, to improve working stability and reliability of the electrical chip 4, an optional implementation is: The optical/electrical hybrid package assembly is disposed to further include: an electrical chip heat sink 100, where the electrical chip heat sink 100 is configured to be laminated to the electrical chip 4.

The electrical chip heat sink 100 may be made of a material having high thermal conductivity and excellent high temperature resistant performance. An optional manner is: The electrical chip heat sink 100 is disposed to be made of a copper material, so that heat dissipation may be rapidly performed on the electrical chip 4 to improve quality and efficiency of heat dissipation. In this way, a working temperature of the electrical chip 4 does not become excessively high, and working stability and reliability of the electrical chip 4 are further ensured.

FIG. 4 is a schematic structural diagram of another embodiment of an optical/electrical hybrid package assembly according to this application. Based on the content described above, it can be learned by continuing to refer to FIG. 3 and FIG. 4 that the first daughter-PCB 2 is disposed on one of surfaces of the mother PCB 5. For example, the first daughter-PCB 2 is disposed on the top surface of the mother PCB 5. When the electrical chip 4 is disposed on the bottom surface of the first daughter-PCB 2, the electrical chip 4 is disposed between the mother PCB 5 and the first daughter-PCB 2, and the optical chip 3 is disposed on the top surface of the first daughter-PCB 2. Therefore, for the optical chip 3, an optical input/output port of the optical chip 3 may be disposed at an upper end or a lateral end of the optical chip 3.

It should be noted that, to improve working stability and reliability of the electrical chip 4, a mounting region 501 configured to mount the electrical chip heat sink 100 may be disposed on the mother PCB 5. The mounting region 501 is configured to mount the electrical chip heat sink 100 that performs heat dissipation on the electrical chip 4. Therefore, quality and efficiency of performing heat dissipation on the electrical chip 4 are effectively ensured. For a structure having a specific shape of the mounting region 501, a manner that can be implemented includes: The mounting region 501 is a groove structure provided on the mother PCB 5, and reference may be made to FIG. 4 for details; or, the mounting region 501 is a through hole structure provided on the mother PCB 5, and reference may be made to FIG. 3 for details.

In addition, the groove structure is not limited to an arc-shaped structure, and structures that have other shapes and that can be implemented include a triangular structure, a rectangular structure, a semicircular structure, a trapezoidal structure, or the like. The groove structure is configured to accommodate the electrical chip heat sink 100. Therefore, it may be understood that when the groove structure has a larger size, a larger quantity of electrical chip heat sinks 100 may be accommodated, to provide better heat dissipation for the electrical chip 4; when the groove structure has a smaller size, a smaller quantity of electrical chip heat sinks 100 may be accommodated. As a result, quality and an effect of heat dissipation of the electrical chip 4 are reduced.

Generally, limited by a thickness of the mother PCB 5, when the mounting region 501 is a groove structure, the groove structure has a relatively small size. Therefore, a relatively small quantity of electrical chip heat sinks 100 are accommodated in the groove structure. As a result, quality of heat dissipation is relatively low. Therefore, to improve quality and efficiency of heat dissipation of the electrical chip heat sink 100, the mounting region 501 may be disposed to be a through hole structure, and a size of the through hole structure may be set to be greater than a size of the electrical chip 4. The through hole structure is configured to mount the electrical chip heat sink 100. In this case, the through hole structure does not limit the quantity of the electrical chip heat sinks 100, so that as many electrical chip heat sinks 100 as possible may be disposed. For example, the electrical chip heat sink 100 may be disposed to include a first lamination portion laminated to the electrical chip 4 and a second lamination portion in contact with the mother PCB 5. In this case, the electrical chip heat sink 100 may rapidly and effectively perform heat dissipation on the electrical chip 4, so that quality and efficiency of performing heat dissipation on the electrical chip 4 are improved.

In the optical/electrical hybrid package assembly in this application, when the electrical chip 4 is disposed between the mother PCB 5 and the first daughter-PCB 2, the mounting region 501 is provided as the groove structure or the through hole structure on the mother PCB 5. In manners that can be implemented for the mounting region 501, quality and efficiency of performing heat dissipation on the electrical chip 4 are ensured, and there are varied manners of providing the mounting region 501, so that application scope of the optical/electrical hybrid package assembly is further improved.

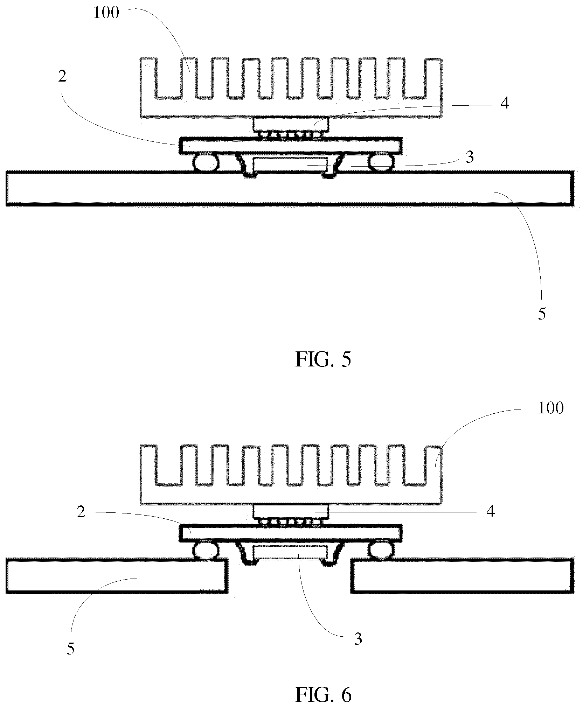

FIG. 5 is a schematic structural diagram of still another embodiment of an optical/electrical hybrid package assembly according to this application. Based on the content described above, it can be learned by continuing to refer to FIG. 5 that in addition to that the optical chip 3 is disposed on the top surface of the first daughter-PCB 2 and the electrical chip 4 is disposed on the bottom surface of the first daughter-PCB 2, another manner that can be implemented is: The optical chip 3 is disposed on the bottom surface of the first daughter-PCB 2, and the electrical chip 4 is disposed on the top surface of the first daughter-PCB 2. In this case, the electrical chip 4 may be laminated to the electrical chip heat sink 100 located at an upper end of the electrical chip 4, and the optical chip 3 is disposed between the mother PCB 5 and the first daughter-PCB 2.

Generally, the optical chip 3 includes: a first-type optical chip having a light emission direction perpendicular to the optical chip 3 and a second-type optical chip having a light emission direction parallel to the optical chip 3. The optical chip 3 is disposed between the mother PCB 5 and the first daughter-PCB 2, and the mother PCB 5 is a complete flat plate structure. Therefore, to ensure communication quality of the optical chip 3, the second-type optical chip is chosen as the optical chip 3 in this application. That is, for the optical chip 3 in this case, the optical input/output port is disposed at the lateral end of the optical chip 3.

FIG. 6 is a schematic structural diagram of yet another embodiment of an optical/electrical hybrid package assembly according to this application. Based on the content described above, it can be learned by continuing to refer to FIG. 6 that when the optical chip 3 is disposed between the mother PCB 5 and the first daughter-PCB 2, the first-type optical chip may be chosen as the optical chip 3 in this application. In this case, to ensure working stability and reliability of the optical chip 3, a through hole configured to be used as an optical input/output channel of the optical chip 3 needs to be provided on the mother PCB 5.

To ensure input and output quality of optical signals, a position of the through hole provided on the mother PCB 5 may be opposite to a position of the optical chip 3. In addition, to reduce difficulty and complexity in production and design, the through hole may be provided to have a size greater than a size of the optical chip 3. In addition, it may be understood that when the second-type optical chip is chosen as the optical chip 3 in this application, the through hole may be similarly provided on the mother PCB 5, and the through hole may similarly improve communication quality of an optical signal. Therefore, the through hole is provided, so that it can be effectively ensured that an optical signal passes through the through hole to reach the optical chip 3, and working stability and reliability of the optical chip 3 are further improved.

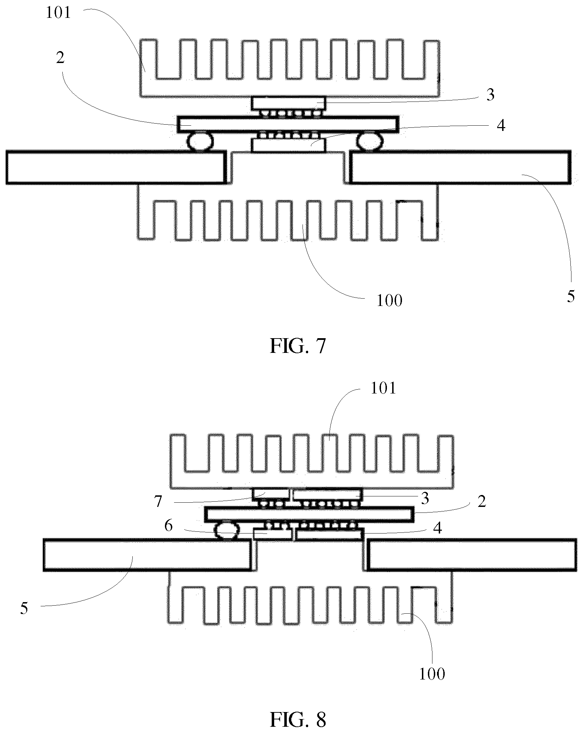

FIG. 7 is a schematic structural diagram of another embodiment of an optical/electrical hybrid package assembly according to this application. Based on the content described above, it can be learned by continuing to refer to FIG. 7 that when the optical chip 3 and the electrical chip 4 work, heat generated by the optical chip 3 is less than heat generated by the electrical chip 4; however, when the optical chip 3 remains in a working state for a long time, a particular amount of heat is generated. Therefore, to improve working stability and reliability of the optical chip 3, an optional implementation is: The optical/electrical hybrid package assembly is disposed to further include: an optical chip heat sink 101, where the optical chip heat sink 101 is configured to be laminated to the optical chip 3.

It may be understood that the optical chip heat sink 101 and the electrical chip heat sink 100 are disposed independently in this application. That is, a same optical/electrical hybrid package assembly may include the optical chip heat sink 101 and/or the electrical chip heat sink 100. The optical chip heat sink 101 may be disposed to have a material the same as that of the electrical chip heat sink 100. During specific design, when the optical/electrical hybrid package assembly includes only the optical chip heat sink 101, a manner that can be implemented includes: When the optical chip 3 is disposed on the top surface of the first daughter-PCB 2, in this case, the optical chip heat sink 101 is disposed on the top surface of the first daughter-PCB 2, and is laminated to the optical chip 3; when the optical chip 3 is disposed on the bottom surface of the first daughter-PCB 2, in this case, the optical chip heat sink 101 is mounted on the mother PCB 5. Therefore, there are two manners in which the optical chip heat sink 101 is disposed: In one manner, the groove structure is disposed on the mother PCB 5, and the optical chip heat sink 101 is disposed in the groove structure; in the other manner, the through hole structure is disposed on the mother PCB 5, and the optical chip heat sink 101 is mounted in the through hole structure. When the optical/electrical hybrid package assembly includes the optical chip heat sink 101 and the electrical chip heat sink 100, the optical chip heat sink 101 and the electrical chip heat sink 100 may be disposed separately in the manners described above, provided that the optical chip heat sink 101 can effectively perform heat dissipation on the optical chip 3 and the electrical chip heat sink 100 can effectively perform heat dissipation on the electrical chip 4.

In the optical/electrical hybrid package assembly provided in this embodiment, the disposed optical chip heat sink 101 is used to perform heat dissipation on the optical chip 3, so that stability and reliability of using the optical chip 3 are effectively ensured, and safety and reliability of using the optical/electrical hybrid package assembly are further improved.

FIG. 8 is a schematic structural diagram of a further embodiment of an optical/electrical hybrid package assembly according to this application. Based on the content described above, it can be learned by continuing to refer to FIG. 8 that during specific application or during specific design, a plurality of chips may be disposed on each surface of the first daughter-PCB 2. Therefore, the optical/electrical hybrid package assembly may be disposed to further include: one or more adjacent optical chips 6, where the adjacent optical chip 6 and the electrical chip 4 are located on a same surface of the first daughter-PCB 2, and a gap is provided between the adjacent optical chip 6 and the electrical chip 4.

It should be noted that the adjacent optical chip 6 is in communication connection to the electrical chip 4. That is, the electrical chip 4 may process electrical signals sent by the one or more adjacent optical chips 6. For some adjacent optical chips 6 that have relatively strict high-frequency performance requirements and the electrical chip 4, a distance between the adjacent optical chip 6 and the electrical chip 4 needs to be set small, that is, the distance of the gap is relatively small, so that high-frequency performance between the adjacent optical chip 6 and the electrical chip 4 can be effectively ensured. By using the foregoing structure, application scope of the optical/electrical hybrid package assembly is effectively extended, and in addition, high-frequency performance between the adjacent optical chip 6 and the electrical chip 4 is further ensured, so that stability and reliability of using the optical/electrical hybrid package assembly are improved.

In addition to that the optical/electrical hybrid package assembly is disposed to include the one or more adjacent optical chips 6, on the other surface of the first daughter-PCB 2, the optical/electrical hybrid package assembly may be further disposed to further include: one or more adjacent electrical chips 7, where the adjacent electrical chip 7 and the optical chip 3 are located on a same surface of the first daughter-PCB 2, and a gap is provided between the adjacent electrical chip 7 and the optical chip 3.

The gap in this application is configured to ensure performance of high-frequency communication between the adjacent electrical chip 7 and the optical chip 3. The adjacent electrical chip 7 is configured to process an electrical signal sent by the optical chip 3. It should be noted that the adjacent electrical chip 7 and the adjacent optical chip 6 are disposed completely independently. That is, for the same first daughter-PCB 2 in the same optical/electrical hybrid package assembly, the electrical chip 4 may be disposed on one surface of the first daughter-PCB 2, and the optical chip 3 and the one or more adjacent electrical chips 7 are disposed on the other surface of the first daughter-PCB 2; or, the electrical chip 4 and the one or more adjacent optical chips 6 may be disposed on one surface of the first daughter-PCB 2, and the optical chip 3 is disposed on the other surface of the first daughter-PCB 2; or, the electrical chip 4 and the one or more adjacent optical chips 6 may be disposed on one surface of the first daughter-PCB 2, and the optical chip 3 and the one or more adjacent electrical chips 7 are disposed on the other surface of the first daughter-PCB 2. When the chips on the two surfaces of the first daughter-PCB 2 include the adjacent optical chip 6 and the adjacent electrical chip 7, there may be communication interaction between the adjacent optical chip 6 and the adjacent electrical chip 7, and there may be data interaction between the adjacent electrical chip 7 and the optical chip 3.

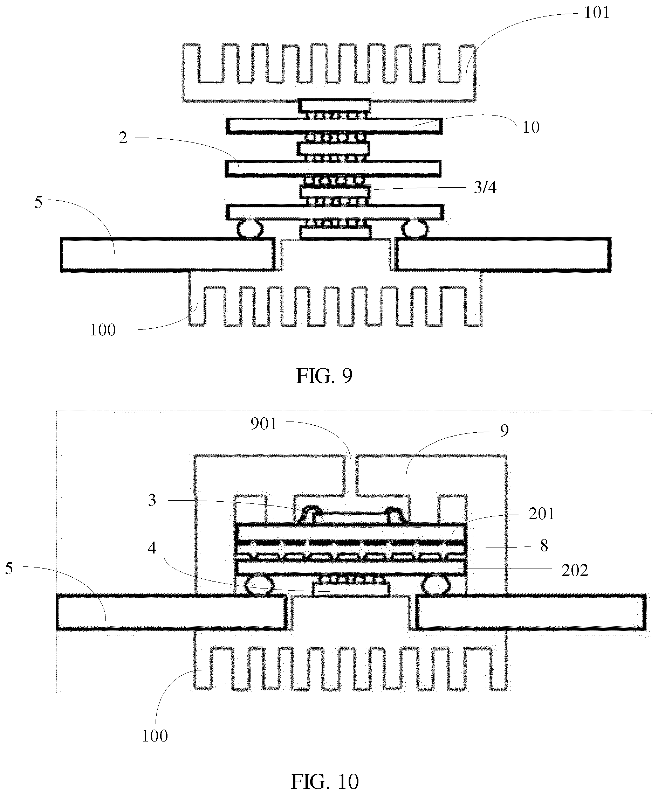

FIG. 9 is a schematic structural diagram of still another embodiment of an optical/electrical hybrid package assembly according to this application. Based on the content described above, it can be learned by continuing to refer to FIG. 9 that during specific design, to further improve volume density in the optical/electrical hybrid package assembly, the optical/electrical hybrid package assembly may be disposed to further include: one or more second daughter-PCBs 10, where the second daughter-PCB 10 and the first daughter-PCB 2 are disposed in a stacked manner, at least one chip is disposed on both a top surface and a bottom surface of the second daughter-PCB 10, and the chips disposed on the top surface and the bottom surface of the first daughter-PCB 2 and the chips disposed on the top surface and the bottom surface of the second daughter-PCB 10 include at least one optical chip 3 and one electrical chip 4.

There may be one, two, three or more second daughter-PCBs 10. For clear understanding of the technical content of this application, an example in which two second daughter-PCBs 10 are disposed is used for description. It can be learned by referring to FIG. 9 that the two second daughter-PCBs 10 are disposed on the top surface and the bottom surface of the first daughter-PCB 2. Certainly, the two second daughter-PCBs 10 may be disposed on the top surface or the bottom surface of the first daughter-PCB 2, provided that it can be ensured that the second daughter-PCB 10 and the first daughter-PCB 2 are disposed in a stacked manner. In addition, at least one chip is disposed on both the top surface and the bottom surface of the second daughter-PCB 10. That is, one, two, three or more chips may be disposed on the top surface of the second daughter-PCB 10. Each chip may be the electrical chip 4 or the optical chip 3. On the bottom surface of the second daughter-PCB 10, one, two, three or more chips may also be disposed. Each chip may be the electrical chip 4 or the optical chip 3. It should be noted that a quantity and types of the chips disposed on the top surface of the second daughter-PCB 10 are completely independent of a quantity and types of the chips disposed on the bottom surface of the second daughter-PCB 10. However, according to processing capabilities of the optical chip 3 and the electrical chip 4, it needs to be ensured that the chips on the top surface and the bottom surface of the first daughter-PCB 2 and the chips disposed on the top surface and the bottom surface of the second daughter-PCB 10 include at least one optical chip 3 and one electrical chip 4, so that working stability and reliability of the optical chip 3 and the electrical chip 4 may be effectively ensured.

In the optical/electrical hybrid package assembly provided in this application, the one or more second daughter-PCBs 10 and the first daughter-PCB 2 are disposed in a stacked manner. While working stability and reliability of the optical chip 3 and the electrical chip 4 are ensured, volume density in the optical/electrical hybrid package assembly is further improved, and there are varied forms of providing the optical/electrical hybrid package assembly, so that practicability and application scope of the optical/electrical hybrid package assembly are further improved.

FIG. 10 is a schematic structural diagram of yet another embodiment of an optical/electrical hybrid package assembly according to this application. Based on the content described above, it can be learned by continuing to refer to FIG. 10 that during specific design, to ensure safety and reliability of using electrical components, a packaging operation needs to be performed on the first daughter-PCB 2, the optical chip 3, and the electrical chip 4. Therefore, to make it easy to integrally package the first daughter-PCB 2 and the chips disposed on the top surface and the bottom surface of the first daughter-PCB 2, the optical/electrical hybrid package assembly is disposed to further include: a fixing apparatus 9 disposed on a surface of the mother PCB 5, where the fixing apparatus 9 is configured to integrally package the first daughter-PCB 2, the optical chip 3, and the electrical chip 4.

The fixing apparatus 9 is disposed on a surface of the mother PCB 5. Specifically, the fixing apparatus 9 may be connected to the mother PCB 5 in a manner of soldering or a binder, and the fixing apparatus 9 may have a rectangular structure, a square structure, a circular structure, or the like. The fixing apparatus 9 is configured to integrally package the first daughter-PCB 2, the optical chip 3, and the electrical chip 4. Therefore, the electrical components that are packaged need to be disposed inside the fixing apparatus 9. It may be understood that the fixing apparatus 9 may be configured to integrally package the first daughter-PCB 2, the optical chip 3, and the electrical chip 4. When the adjacent optical chip 6 and the adjacent electrical chip 7 are further disposed on the top surface and the bottom surface of the first daughter-PCB 2, the fixing apparatus 9 may integrally package the first daughter-PCB 2, the optical chip 3, the electrical chip 4, the adjacent optical chip 6, and the adjacent electrical chip 7. When the one or more second daughter-PCBs 10 are stacked on the first daughter-PCB 2, the fixing apparatus 9 may further integrally package the first daughter-PCB 2, the optical chip 3, the electrical chip 4, the adjacent optical chip 6, the adjacent electrical chip 7, and the second daughter-PCB 10. In addition, the fixing apparatus 9 may further integrally package the electrical chip heat sink 100 and/or the electrical chip heat sink 100 and the foregoing corresponding electrical components, so that safety and reliability of using the foregoing electrical components are ensured.

It should be noted that the optical chip 3 needs to receive and send an optical signal, and therefore, to ensure reliability of using the optical chip 3, a communications port 901 configured to be used as the optical input/output channel of the optical chip 3 is disposed on the fixing apparatus 9. The communications port 901 may have a circular structure, a rectangular structure, a square structure, a trapezoidal structure, or the like. To further improve quality and efficiency of sending an optical signal, an optional implementation is: For the optical chip 3 having a light emission direction perpendicular to the chip, the communications port 901 may be disposed at a position opposite to a position of the optical chip 3; for the optical chip 3 having a light emission direction parallel to the chip, the communications port 901 may be disposed at a position in parallel to the position of the optical chip 3, so that quality and efficiency of receiving a signal by the optical chip 3 may be effectively ensured.

In the optical/electrical hybrid package assembly in this application, the disposed fixing apparatus 9 may integrally package the first daughter-PCB 2, the optical chip 3, and the electrical chip 4, so that working stability and reliability of the foregoing components are effectively ensured, service life of the optical/electrical hybrid package assembly is extended, and safety and reliability of using the optical/electrical hybrid package assembly are improved.

Based on the content described above, it can be learned by continuing to refer to FIG. 10 that during specific design, the optical chip 3 and the electrical chip 4 separately have different soldering processes. During soldering of a chip, to avoid mutual interference between a process of soldering the optical chip 3 and a process of soldering the electrical chip 4, the first daughter-PCB 2 may be disposed to include: a first daughter-PCB layer 201 and a second daughter-PCB layer 202, where the first daughter-PCB layer 201 is connected to the second daughter-PCB layer 202 by using an interposer 8.

The first daughter-PCB layer 201 and the second daughter-PCB layer 202 are connected back to back by using the interposer 8. The interposer 8 is configured to isolate the first daughter-PCB layer 201 from the second daughter-PCB layer 202. In this way, when the optical chip 3 is disposed at an upper end of the first daughter-PCB layer 201, the electrical chip 4 is disposed at a lower end of the second daughter-PCB layer 202. During a soldering operation, the optical chip 3 may be soldered on the first daughter-PCB layer 201, the electrical chip 4 is soldered on the second daughter-PCB layer 202, and then the first daughter-PCB layer 201 soldered with the optical chip 3 is connected, by using the interposer 8, to the second daughter-PCB layer 202 soldered with the electrical chip 4, so that it is implemented that the process of soldering the optical chip 3 and the process of soldering the electrical chip 4 do not interfere with each other, and an effect of soldering the optical chip 3 and the electrical chip 4 is effectively ensured. In addition, it should be noted that the second daughter-PCB 10 in this application may use a structure that is the same as that of the first daughter-PCB 2, that is, includes the first daughter-PCB layer 201 and the second daughter-PCB layer 202; and the fixing apparatus 9 can still be disposed on the foregoing structure. The fixing apparatus 9 is configured to integrally package at least the first daughter-PCB layer 201, the second daughter-PCB layer 202, the optical chip 3, and the electrical chip 4.

In addition, to understand more clearly a mounting process of the optical/electrical hybrid package assembly in this application, an example in which the optical chip 3 is disposed on a top surface of the first daughter-PCB layer 201 and the electrical chip 4 is disposed on a bottom surface of the second daughter-PCB layer 202 is used for description. The optical chip 3 may be attached on the first daughter-PCB layer 201, the optical chip 3 may be attached on the second daughter-PCB layer 202, and the second daughter-PCB layer 202 may then be soldered on the mother PCB 5. The first daughter-PCB layer 201 and the second daughter-PCB layer 202 on which chips are attached are connected back to back by using one interposer 8. The interposer 8 usually uses a crimping manner. The fixing apparatus 9 disposed in advance applies a pressure to the first daughter-PCB layer 201 to keep the first daughter-PCB layer 201, the second daughter-PCB layer 202, the optical chip 3, the electrical chip 4, and the mother PCB 5 in desirable contact.

In the optical/electrical hybrid package assembly provided in this application, the first daughter-PCB 2 is disposed to include the first daughter-PCB layer 201, the second daughter-PCB layer 202, and the interposer 8 disposed between the first daughter-PCB layer 201 and the second daughter-PCB layer 202, so that the first daughter-PCB layer 201 is effectively isolated from the second daughter-PCB layer 202, mutual interference between the process of soldering the optical chip 3 and the process of soldering the electrical chip 4 is avoided, stability and reliability of mounting the optical chip 3 and the electrical chip 4 are ensured, stability and reliability of using the optical/electrical hybrid package assembly are further improved, and in addition, service life of the optical/electrical hybrid package assembly is extended.

## Claims

1. An optical/electrical hybrid package assembly, comprising:
a mother PCB;
a first daughter-PCB, wherein the first daughter-PCB is disposed on one of surfaces of the mother PCB;
an optical chip, disposed on one surface of the first daughter-PCB; and
an electrical chip, disposed on the other surface of the first daughter-PCB.

2. The optical/electrical hybrid package assembly according to claim 1, further comprising: an electrical chip heat sink, wherein the electrical chip heat sink is configured to be laminated to the electrical chip.

3. The optical/electrical hybrid package assembly according to claim 2, wherein the electrical chip is disposed between the mother PCB and the first daughter-PCB.

4. The optical/electrical hybrid package assembly according to claim 3, wherein a mounting region configured to mount the electrical chip heat sink is disposed on the mother PCB.

5. The optical/electrical hybrid package assembly according to claim 4, wherein the mounting region is a groove structure provided on the mother PCB; or, the mounting region is a through hole structure provided on the mother PCB.

6. The optical/electrical hybrid package assembly according to claim 2, wherein the optical chip is disposed between the mother PCB and the first daughter-PCB.

7. The optical/electrical hybrid package assembly according to claim 6, wherein a through hole configured to be used as an optical input/output channel of the optical chip is disposed on the mother PCB.

8. The optical/electrical hybrid package assembly according to any one of claims 1 to 7, further comprising: an optical chip heat sink, wherein the optical chip heat sink is configured to be laminated to the optical chip.

9. The optical/electrical hybrid package assembly according to any one of claims 1 to 7, further comprising: one or more adjacent optical chips, wherein the adjacent optical chip and the electrical chip are located on a same surface of the first daughter-PCB, and a gap is provided between the adjacent optical chip and the electrical chip.

10. The optical/electrical hybrid package assembly according to any one of claims 1 to 7, further comprising: one or more adjacent electrical chips, wherein the adjacent electrical chip and the optical chip are located on a same surface of the first daughter-PCB, and a gap is provided between the adjacent electrical chip and the optical chip.

11. The optical/electrical hybrid package assembly according to any one of claims 1 to 7, further comprising: one or more second daughter-PCBs, wherein the second daughter-PCB and the first daughter-PCB are disposed in a stacked manner, at least one chip is disposed on both a top surface and a bottom surface of the second daughter-PCB, and the chips disposed on a top surface and a bottom surface of the first daughter-PCB and the chips disposed on the top surface and the bottom surface of the second daughter-PCB comprise at least one optical chip and one electrical chip.

12. The optical/electrical hybrid package assembly according to any one of claims 1 to 7, further comprising: a fixing apparatus disposed on a surface of the mother PCB, wherein the fixing apparatus is configured to integrally package the first daughter-PCB, the optical chip, and the electrical chip.

13. The optical/electrical hybrid package assembly according to claim 12, wherein the first daughter-PCB comprises: a first daughter-PCB layer and a second daughter-PCB layer, wherein the first daughter-PCB layer is connected to the second daughter-PCB layer by using an interposer.

14. The optical/electrical hybrid package assembly according to claim 12, wherein a communications port configured to be used as the optical input/output channel of the optical chip is disposed on the fixing apparatus.
